# EUROPEAN PATENT SPECIFICATION

(11) **EP 3 248 214 B1**
(45) Date of publication and mention of the grant of the patent: **01.12.2021**
(21) Application number: 16709160.2
(22) Date of filing: 21.01.2016
(51) Int. Cl.: H01L 21/28, H01L 29/423, H01L 29/66, H01L 29/788, H01L 27/11524, H01L 27/11536, H01L 21/306

(54) **METHOD OF FORMING SELF-ALIGNED SPLIT-GATE MEMORY CELL ARRAY WITH METAL GATES AND LOGIC DEVICES**
VERFAHREN ZUR HERSTELLUNG EINES SELBSTAUSGERICHTETEN SPEICHERZELLENARRAYS MIT GETEILTEM GATE MIT METALLGATES UND LOGISCHEN VORRICHTUNGEN
PROCÉDÉ DE FORMATION D'UNE MATRICE DE CELLULES DE MÉMOIRE À GRILLE SÉPARÉE AUTO-ALIGNÉES AVEC GRILLES MÉTALLIQUES ET DISPOSITIFS LOGIQUES

(30) Priority: 23.01.2015 US 201562107077 P
(43) Date of publication of application: 29.11.2017
(73) Proprietor: Silicon Storage Technology Inc., San Jose, CA 95134 (US)
(72) Inventor: YANG, Jeng-Wei, Zhubei City Hsinchu County 302 (TW); CHEN, Chun-Ming, Banqiao Dist. New Taipei City 220 (TW); WU, Man-Tang, Xin Pu Township Hsinchu County 305 (TW); ZHOU, Feng, Fremont, CA 94536 (US); LIU, Xian, Sunnyvale, CA 94087 (US); SU, Chien-Sheng, Saratoga, CA 95070 (US); DO, Nhan, Saratoga, CA 95070 (US)
(74) Representative: Betten & Resch
(86) International application number: PCT/US2016/014393
(87) International publication number: WO 2016/118785

(56) References cited:
- US-A1- 2003 139 010
- US-A1- 2003 139 010
- US-A1- 2009 039 410
- US-A1- 2014 126 299
- US-A1- 2014 374 815
- US-A1- 2014 374 815
- US-A1- 2014 374 815

## Description

### FIELD OF THE INVENTION

The present invention relates to non-volatile memory cell arrays.

### BACKGROUND OF THE INVENTION

It is well known in the art to form split-gate memory cells as an array of such cells. For example, U.S. Patent 7,868,375 discloses an array of memory cells, where each memory cell includes a floating gate, a control or coupling gate, a select gate, an erase gate, all formed on a substrate with a channel region defined between a source and drain regions. For efficient use of space, the memory cells are formed in pairs, with each pair sharing a common source region and erase gate.

It is also known to form both low voltage and high voltage logic devices on the same wafer die as the array of memory cells. Such logic devices can include transistors each having a source and drain, and a poly gate controlling the conductivity of the channel region between the source and drain.

US 2009/039410 A1 discloses an improved split gate non-volatile memory cell being made in a substantially single crystalline substrate of a first conductivity type, having a first region of a second conductivity type, a second region of the second conductivity type, with a channel region between the first region and the second region in the substrate. The cell has a select gate above a portion of the channel region, a floating gate over another portion of the channel region, a control gate above the floating gate and an erase gate adjacent to the floating gate. The erase gate has an overhang extending over the floating gate. The ratio of the dimension of the overhang to the dimension of the vertical separation between the floating gate and the erase gate is between approximately 1.0 and 2.5, which improves erase efficiency.

US 2014/126299 A1 discloses a semiconductor device having a semiconductor layer, a floating gate electrode provided over the semiconductor layer via a first insulation film, and an erase gate electrode to which an erase voltage is applied. The floating gate electrode has an opposing region that opposes via a second insulation film to the erase gate electrode. The opposing region has such a shape that multiple electric field concentrating portions are formed when the erase voltage is applied to the erase gate electrode.

US 2014/374815 A1 discloses an embedded flash memory device including a gate stack, which includes a bottom dielectric layer extending into a recess in a semiconductor substrate, and a charge storage layer over the bottom dielectric layer. The charge storage layer includes a portion in the recess. The gate stack further includes a top dielectric layer over the charge storage layer, and a metal gate over the top dielectric layer. Source and drain regions are in the semiconductor substrate, and are on opposite sides of the gate stack.

US 2003/139010 A1 discloses a self-aligned method of forming a semiconductor memory array of floating gate memory cells in a semiconductor substrate having a plurality of spaced apart isolation regions and active regions on the substrate substantially parallel to one another in the column direction, and an apparatus formed thereby. Floating gates are formed in each of the active regions. In the row direction, trenches are formed that are filled with a conducting material such as metal or metalized polysilicon to form blocks of the conducting material that constitute source lines. Each source line extends over and is electrically connected to one of the source regions in each of the active regions.

### BRIEF SUMMARY OF THE INVENTION

The present invention is defined in independent claim 1. The dependent claims define embodiments of the invention.

Other objects and features of the present invention will become apparent by a review of the specification, claims and appended figures.

### BRIEF DESCRIPTION OF THE DRAWINGS

Figs. 1A to 7A are side cross sectional views (in the cell WL direction in the memory area) showing the steps in forming the memory cell device of the present invention.
Figs. 1B to 7B are side cross sectional views (in the cell BL direction) showing the steps in forming the memory cell device of the present invention.
Figs. 8-26 are side cross sectional views showing the steps in forming the memory cell device of the present invention.
Fig. 27 is a side cross sectional view showing an alternate embodiment of the memory cell device of the present invention.

### DETAILED DESCRIPTION OF THE INVENTION

The present invention is a technique for forming self-aligned split-gate memory cells with metal gates, and both low and high voltage logic devices on the same wafer die as the memory cell array.

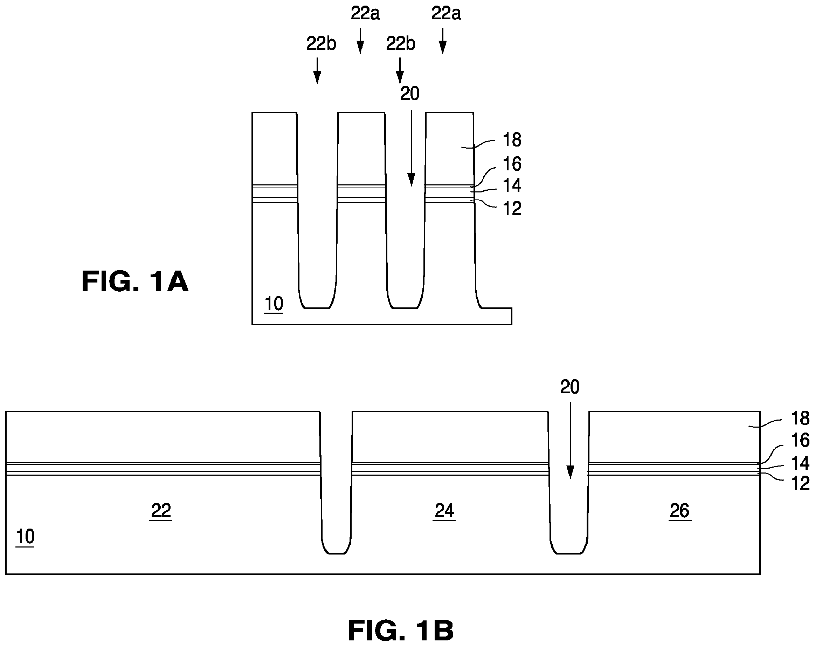

The process begins by providing a semiconductor substrate 10. An oxide layer 12 is formed on the substrate 10. A first polysilicon (poly) layer 14 is formed on the oxide layer 12. A nitride layer 16 is formed on the poly layer 14. The nitride layer 16 can include a BARC coating thereon. The structure is patterned using a photolithography photo resist deposition 18, mask exposure and photo resist etch. BARC, nitride, poly, oxide and silicon etches are performed on the exposed portions of the structure to form trenches 20 extending through all these layers and into the substrate 10. The trenches 20 divide the substrate into one or more memory cell areas 22, one or more HV/MV device areas 24, and one or more core device areas 26, and divide the memory cell area 22 into active regions 22a and isolation regions 22b. The resulting structure is shown in Fig. 1A (cross section in the cell WL direction, in the memory area 22) and Fig. 1B (cross section in the cell BL direction).

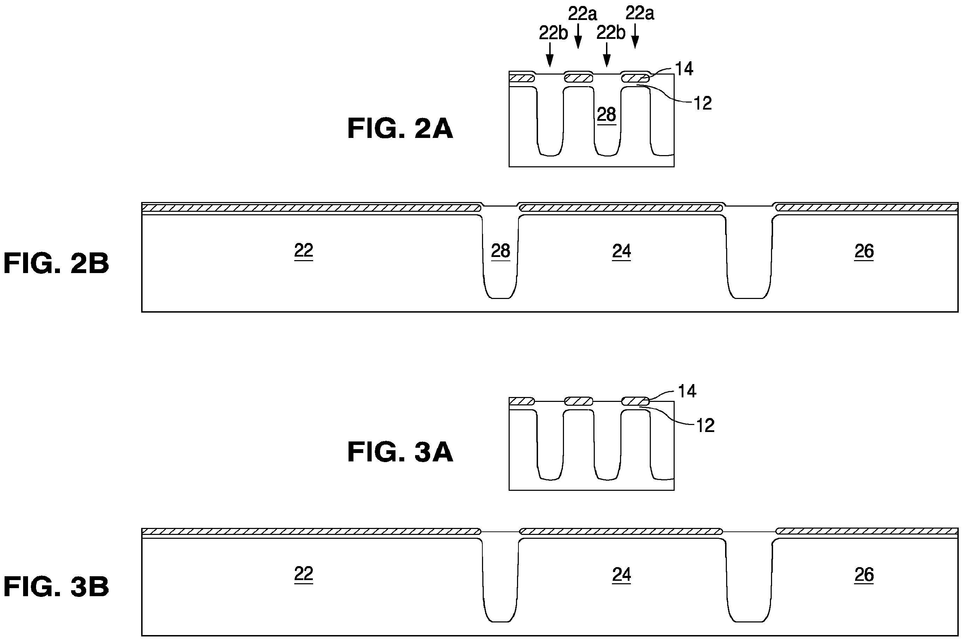

After photo resist 18 is removed, the trenches 20 are filled with insulation material (e.g. STI oxide). Preferably, this involves a conventional STI process where the trenches are lined with an oxide layer, followed by oxide deposition, anneal and CMP (chemical mechanical polish) oxide etch. The nitride layer 16 is then removed by a nitride etch. The resulting structure is shown in Figs. 2A and 2B.

Preferably, a poly implant is performed on the exposed poly layer 14. Then, an oxide etch is used to lower the upper surface of the STI insulation 28 below that of the poly layer 14, as shown in Figs. 3A and 3B.

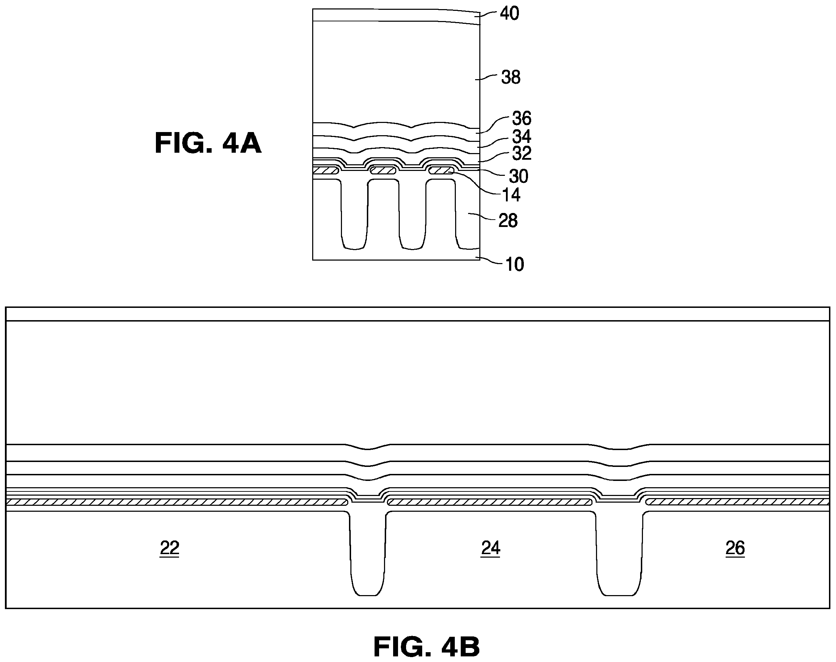

An ONO (oxide, nitride, oxide) insulation 30 is formed over the structure by oxide, nitride, oxide deposition and anneal. A second poly layer 32 is formed over the structure, followed by a poly implant and anneal. Next, a nitride layer 34 is formed on the structure, followed by an oxide layer 36, followed by another nitride layer 38, followed by another oxide layer 40, as shown in Figs. 4A and 4B.

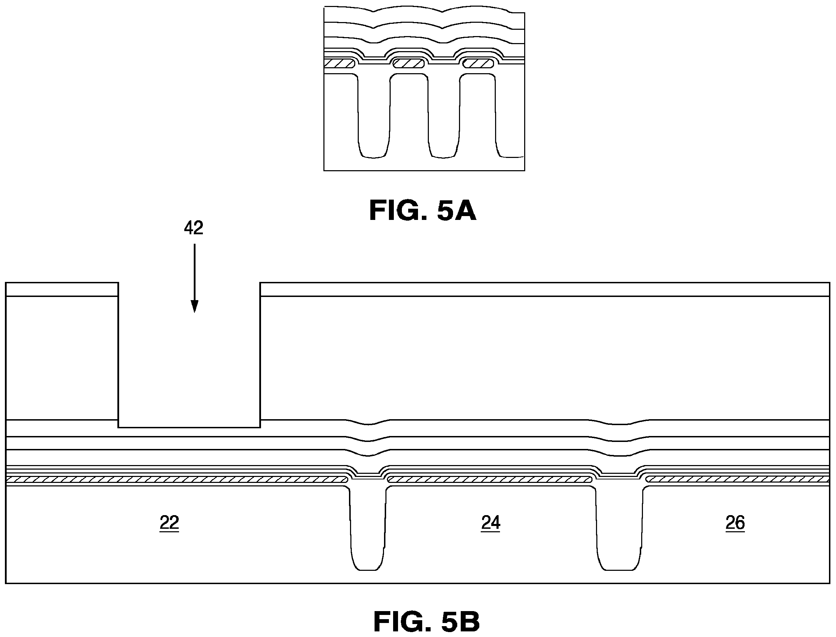

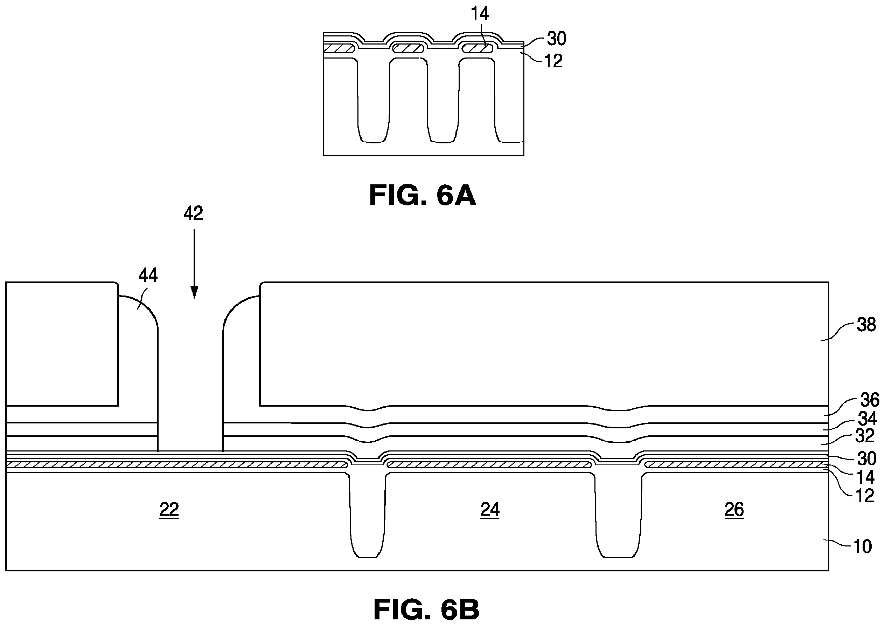

A photolithography process (photo resist, mask exposure and etch) is used to selectively expose portions of the structure in the memory cell area 22. Oxide, nitride and oxide etches are used to form trenches 42 into the exposed portions of the structure, as shown in Figs. 5A and 5B (after photo resist removal). An oxide deposition and etch is performed to form spacers 44 of oxide along the sidewalls of the trench 42. Formation of spacers is well known in the art, and involves the deposition of a material over the contour of a structure, followed by an anisotropic etch process, whereby the material is removed from horizontal surfaces of the structure, while the material remains largely intact on vertically oriented surfaces of the structure (with a rounded upper surface). A nitride etch is used to remove the exposed portions of the nitride layer 34 at the bottom of the trenches 42 (between the spacers 44). A poly etch is then used to remove the exposed portions of the second poly layer 32 at the bottom of the trenches 42 (between the spacers 44). The resulting structure is shown Figs. 6A and 6B.

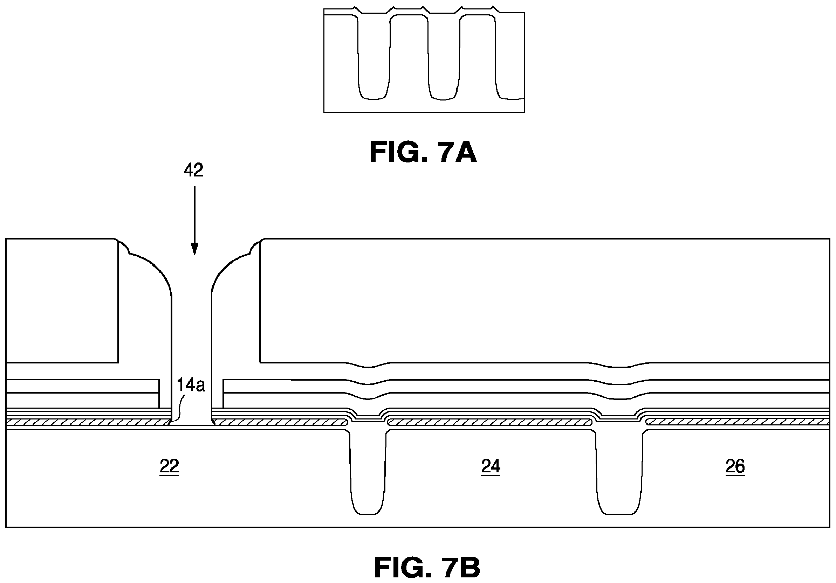

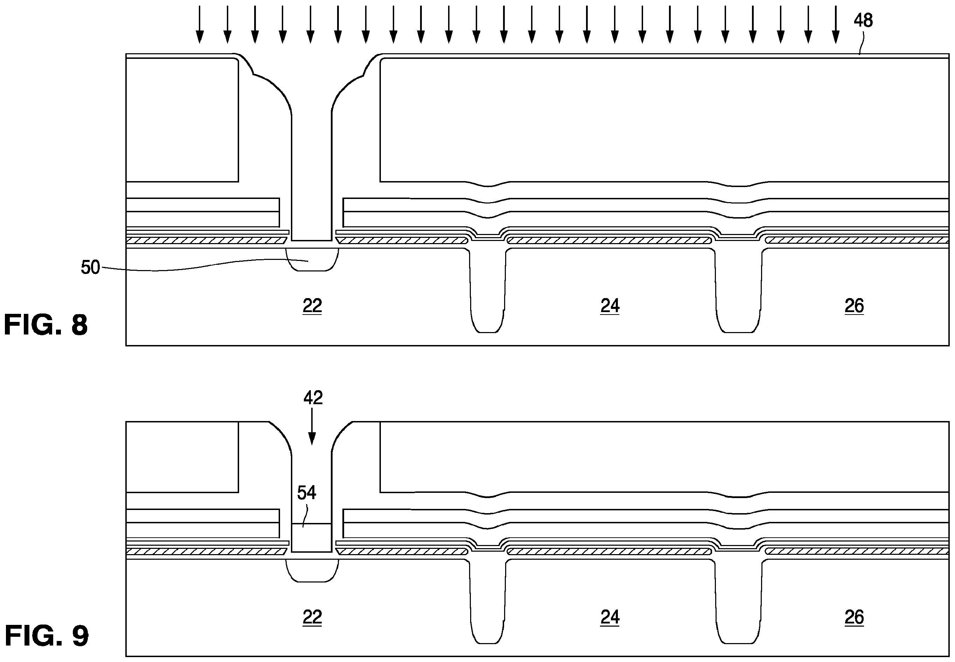

An HTO (hot thermal oxide) deposition is performed to form a layer of oxide 46 on the structure (and in the trenches 42), followed by an HTO anneal. Then, oxide, ONO and poly etches are performed to extend the trenches 42 down to oxide layer 12. The poly etch is preferably isotropic, so that there is a slight undercut 14a (i.e. negative slope) to the side wall of the first poly layer 14. The resulting structure is shown in Figs. 7A and 7B. A screening oxide layer 48 is then deposited on the structure, followed by an implant and anneal for forming source (first) regions 50 in the substrate below the trenches 42, as shown in Fig. 8.

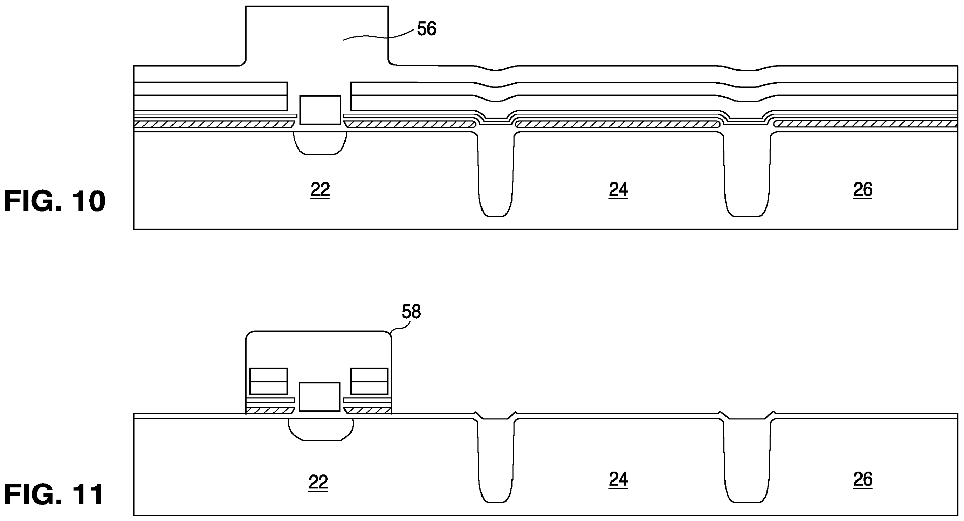

An oxide etch is performed to remove the screening oxide layer 48. An oxide deposition is then performed to form a tunnel oxide 52 at the undercut edges of the first poly layer 14. Polysilicon is then deposited on the structure, followed by a poly CMP etch back, which fills the trenches with polysilicon. A further poly etch-back leaves a block of polysilicon 54 at the bottom of each trench 42, as shown in Fig. 9. An oxide deposition and CMP oxide etch is used to fill the trenches 42 with oxide 56. A nitride etch is then used to remove the nitride layer 38, as shown in Fig. 10.

An oxide etch is performed to remove oxide layer 36 and expose the underlying nitride layer 34. A nitride etch is then used to remove the exposed portions of the nitride layer 34, followed by a poly etch to remove the exposed portions of the second poly layer 32. An HTO deposition and anneal is performed. Then, an HTO, ONO and poly etch are performed to remove the exposed portions of the ONO layer 30 and the first poly layer 14, as shown in Fig. 11, leaving a stack structure 58 that constitutes a pair of memory cells. While only a single stack structure 58 is shown, it should be appreciated that there is an array of such stack structures in the memory cell area 22.

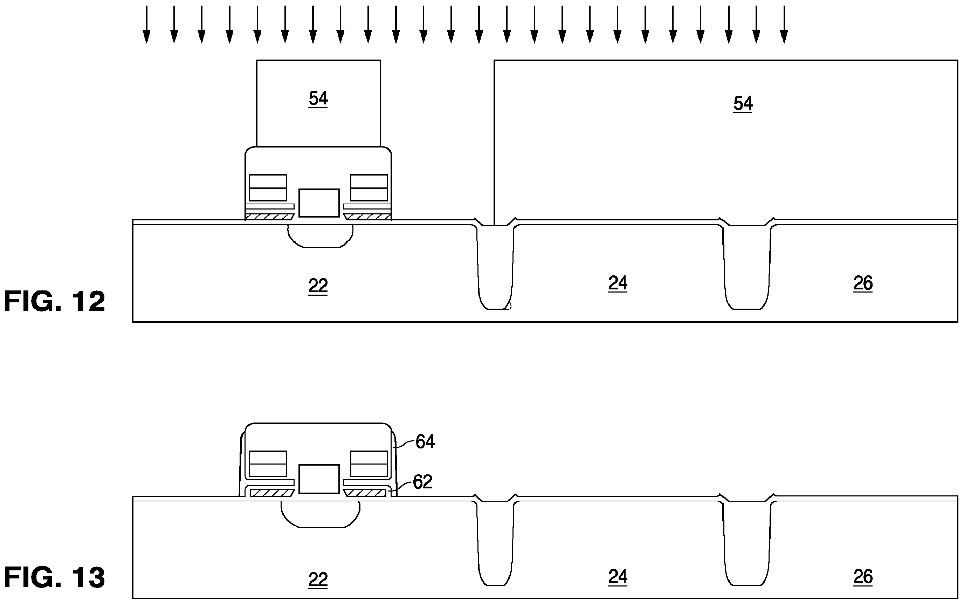

Photo resist 60 is then formed on the structure, and selectively removed from those portions in the memory cell area adjacent to each stack structure 58. An implant process is then performed on the corresponding portions of the substrate (over which the word line gates will eventually be formed), as shown in Fig. 12. After the photo resist 54 is removed, a thermal oxidation is performed to form oxide 62 on the exposed sides of the first poly layer 14. A nitride deposition and nitride etch are performed to form nitride spacers 64 on the sides of the stack structure 58, as shown in Fig. 13.

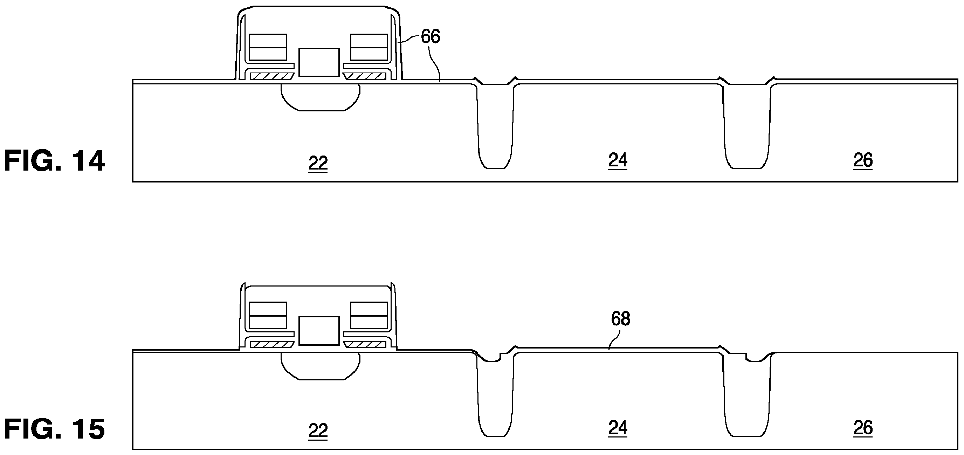

At this stage, photo resist can be formed and selectively removed to selectively expose various portions of the wafer for implantation. For example, word line implants and Vt implants in the HV/MV device area and core device area can be performed. An oxide etch is then used to remove the exposed portions of oxide layer 12 on the substrate surface. Oxide 66 (layer of oxide on substrate and spacers of oxide along stack structure sidewalls) is then formed on the structure by RTO and HTO, followed by HTO anneal, as shown in Fig. 14.

At this stage, photo resist can be formed and selectively removed to selectively expose various portions of the wafer for further implantation. For example, P-well and N-well implants can be performed in the core device area as needed. Photo resist is then formed over the memory cell area 22 and core device area 26, leaving the HV/MV device area 24 exposed. An oxide etch is used to remove the oxide 66 on the substrate surface in the HV/MV device area 24, followed by an oxidation process to form a thicker oxide layer 68. After the photo resist is removed, additional photo resist is formed over the HV/MV device area 24, leaving the memory cell area 22 and core device area 26 exposed to an oxide etch that removes the oxide layer 66 on the substrate surface, the oxide spacers 66 along the memory cell area structure 58, and the oxide along the top surface of the memory cell area structure, as shown in Fig. 15 (after the photo resist is removed).

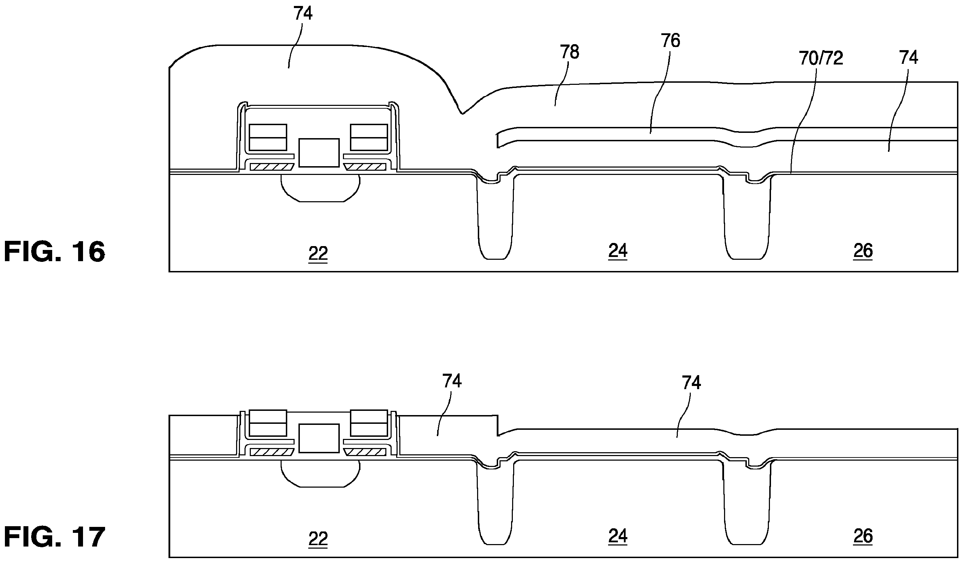

A layer of high-K insulation material 70 is formed over the structure, followed by the formation of a TiN layer 72, a third layer of poly silicon 74, and an oxide layer 76. The oxide layer is patterned using photolithography to remove the oxide layer 76 from the memory cell area 22, but leave it intact in the HV/MV device 24 and core device areas 26. Another poly deposition is then performed to thicken the poly 74 in the memory cell area 22, and to form polysilicon layer 78 over the oxide layer 76 in the HV/MV device and core device areas, as shown in Fig. 16.

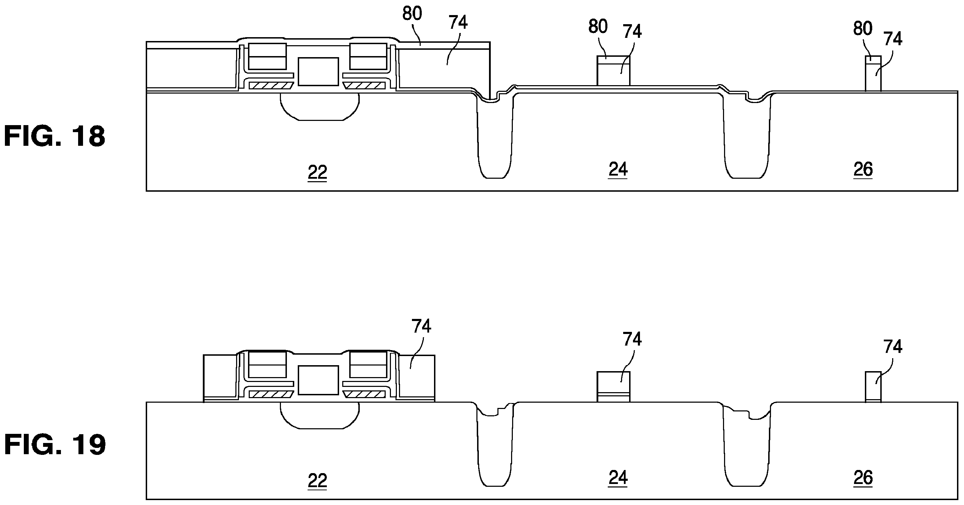

After a BARC coating, a poly etch is performed to thin the poly layer 74 and remove poly layer 78. Then, the oxide layer 76 is removed by an oxide etch, leaving poly layer 74 with a larger thickness in the memory cell area 22 relative to the thickness thereof in the HV/MV device and core device areas 24/26, as shown in Fig. 17. An oxide layer 80 is formed over the structure, which is patterned by photolithography to selectively expose portions of the underlying poly 74. A poly etch is performed on the exposed poly portions leaving blocks of the poly 74 in the various areas, as shown in Fig. 18 (after the removal of the photolithography photo resist).

The oxide layer 80 is again patterned using photolithography (i.e. photo resist deposition, mask exposure, poly etch, oxide etch), to remove portions of the oxide layer 80 in the memory cell area, leaving underlying portions of the poly blocks 74 exposed. After photo resist removal, a poly etch is then performed to remove those exposed portions of poly blocks 74 (i.e. to reduce the width of the poly blocks 74 in the memory cell area 22). A TiN etch is then performed to remove the exposed portions of the TiN layer 72. An oxide etch is then performed which removes the oxide layer 80 over the poly blocks 74, and removes the high K insulator 70 on the substrate surface. The resulting structure is shown in Fig. 19.

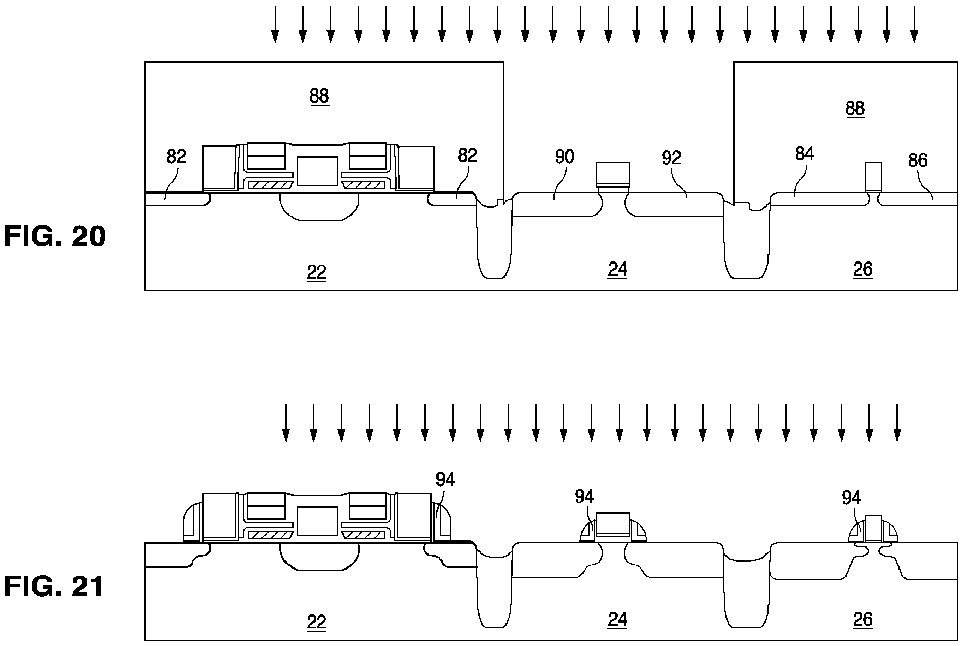

An oxidation process is used to form a layer of oxide on the exposed surface portions of the substrate. A series of implants are then performed to form the source/drain regions in the various areas. For example, photo resist is formed over the structure, and removed only from the memory cell area 22. Then, an LDD implant is performed to form the drain regions 82. After photo resist removal, additional photo resist is formed over the structure, and removed only from the core device area 26. Then, an implant is performed to form the source and drain regions 84 and 86 in the core device area 26. An oxide etch is then performed to remove the oxide layer on the substrate surface in the core device area 26. After photo resist removal, additional photo resist 88 is formed over the structure, and removed only from the HV/MV device area 24. Then, a high voltage implant is performed to form the source and drain regions 90 and 92 in the HV/MV device area 24, as shown in Fig. 20 (after an oxide etch is used to remove the oxide layer on the substrate surface in the HV/MV device area 24). By separating the implantations, the various source/drain regions in the three areas can be formed with different breakdown voltages, and accommodates the formation of the various areas in wells of different conductivity type (i.e. P-well versus N-well).

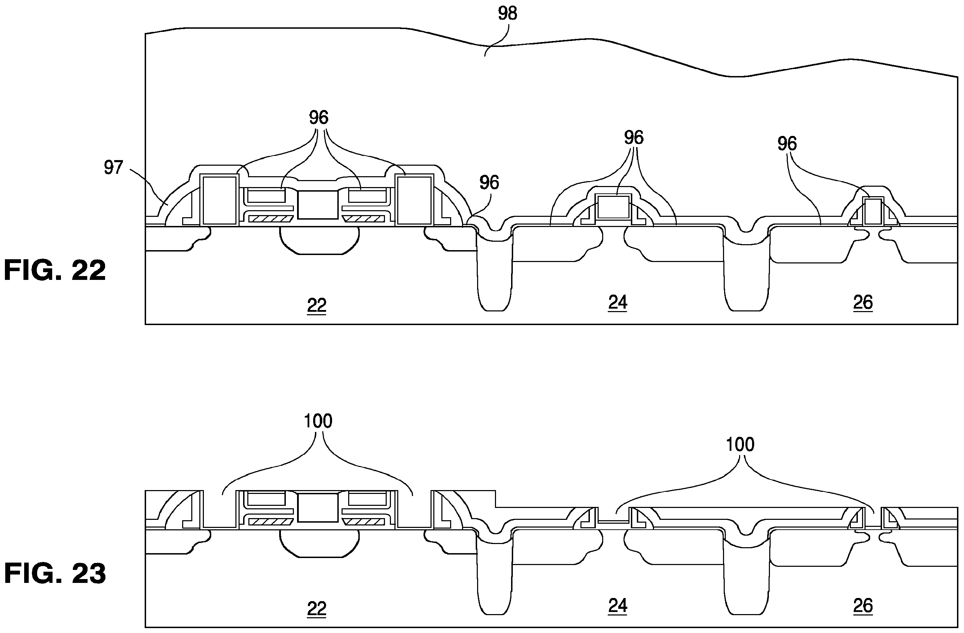

After photo resist removal, oxide and nitride depositions and etch back are performed to form oxide/nitride spacers 94 along the sidewalls of the structures. Additional implants can be performed to complete the source/drain region formation, where the spacers block this implantation such that graded junctions results, as shown in Fig. 21. Photoresist is formed over the structure and selectively removed via photolithography to selectively expose the structures in the memory cell area 22. An oxide etch is then performed to remove the oxide on the poly blocks in the memory cell area 22. After photo resist removal, silicide 96 is formed on the exposed top surfaces of the poly blocks and the exposed upper surface of the substrate. Insulation materials 97 (e.g. oxide) and 98 (e.g. ILDO - interlayer dielectric) are then formed over the structure. The resulting structure is shown in Fig. 22.

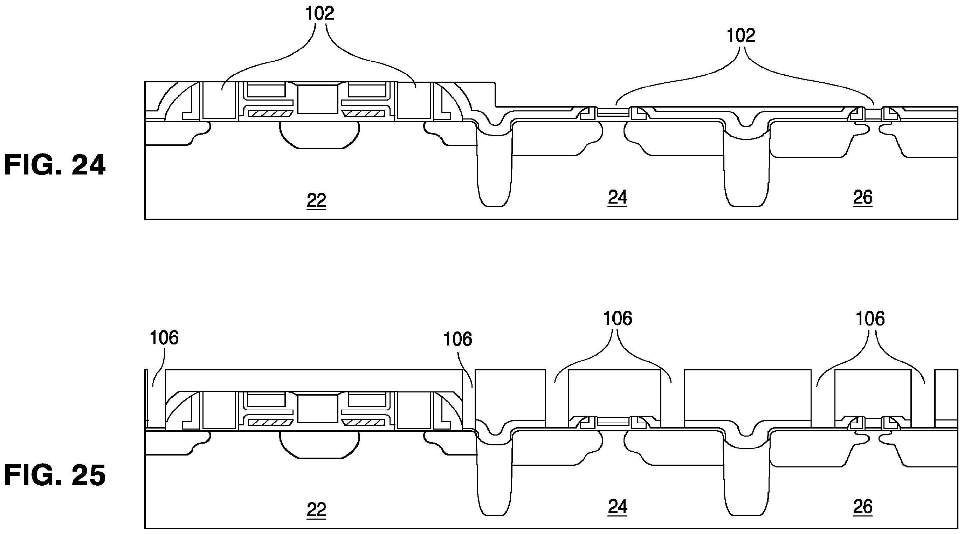

ILDO etches are performed to expose the poly blocks 74 in the HV/MV device and core device areas 24/26, and to expose the outer poly blocks 74 for each stack structure 58 in the memory cell area 22. Patterned photo resist can be used to protect the memory cell area for additional ILDO etching in the HV/MV device and core device areas to reach the poly blocks 74 in those areas. The exposed poly blocks 74 are then removed by a poly etch, leaving trenches 100 as shown in Fig. 23. The trenches 100 are filled with blocks of metal material 102 by metal deposition and etch back (i.e., forming metal gates for the logic devices and memory cells). The metal deposition and etch back can be performed separately for the different areas using protective photo resist for the other areas. The resulting structure is shown in Fig. 24.

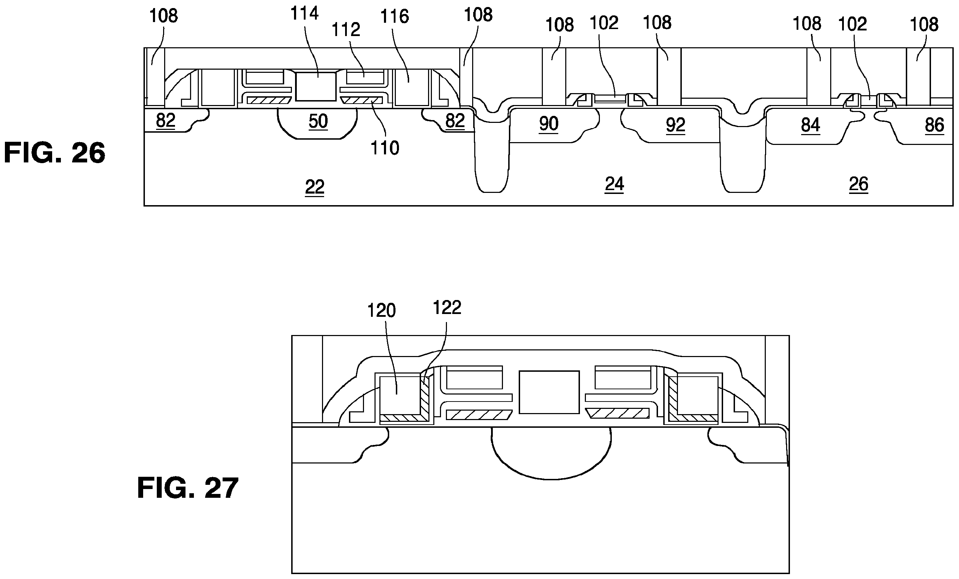

Insulation material 104 (e.g. ILDO) is then formed over the structure and planarized using a CMP etch. Photo resist is then formed on the structure and patterned by photo lithography to selectively expose the insulation material. A etch is then used to remove the exposed portions of the insulation material, to create contact holes 106 through the insulation material 104 down to and exposing the source and drain regions, as shown in Fig. 25 (after photo resist removal). The contact holes 106 are then filled with an appropriate conductive material to create electrical contacts 108 for the source/drain regions. The final structure is shown in Fig. 26.

The memory cells each include source and drain regions 50 and 82, polysilicon floating gate 110, polysilicon control (coupling) gate 112, polysilicon erase gate 114, and a metal word line or select gate 116. The memory cells are formed in pairs, sharing a common erase gate 114 and common source region 50. Each logic device in the HV/MV device area 24 includes source and drain regions 90/92, and a metal gate 102. Each logic device in the core device area 26 includes source and drain regions 84/86, and a metal gate 102.

The above describe formation process has many advantages. First, the memory cells and logic devices are fully formed in a self-aligned process before their poly gates are removed and replaced with metal material. The memory cell components, especially the floating gate, control gate, the erase gate and the tunnel oxide between the floating and erase gates, are formed first and protected by insulation material from the later implemented metal gate formation processing. The sides of the floating gate are formed by separate processing steps, so that the floating gate sidewall over the source region can be formed with a slight undercut to enhance the sharp edge facing the erase gate, while the floating gate sidewall adjacent the select gate is formed with a vertical orientation. Many elements are self-aligned to each other, which reduces the number of required photolithography masking steps.

It is to be understood that the present invention is defined by the appended claims. Materials, processes and numerical examples described above are exemplary only, and should not be deemed to limit the claims. Further, as is apparent from the claims and specification, not all method steps need be performed in the exact order illustrated or claimed, but rather in any order that allows the proper formation of the pairs of memory cells and associated logic devices. Single layers of material could be formed as multiple layers of such or similar materials, and vice versa. Lastly, the metal select gates 116 could be made of a composite of conductive materials. For example, instead of being made of a block of solid metal, the select gates 116 could instead be formed of L-shaped metal material 120, and a block of polysilicon 122, as shown in Fig. 27. As another example, the select gates 116 can remain polysilicon (i.e. outer poly blocks 74 in memory cell area 22 shown in Fig. 22 are not removed and replaced with metal blocks as shown in Figs. 23-24).

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements therebetween.

## Claims

1. A method of forming a memory device, comprising:
forming, in a substrate (10) of a first conductivity type, spaced apart first and second regions (50, 82) of a second conductivity type, defining a channel region therebetween;
forming a floating gate (110) disposed over and insulated from a first portion of the channel region which is adjacent the first region (50);
forming a control gate (112) disposed over and insulated from the floating gate (110);
forming an erase gate (114) disposed over and insulated from the first region (50);
forming a select gate (116) over and insulated from a second portion of the channel region which is adjacent to the second region (82);
forming a first logic gate (102) over and insulated from the substrate (10);
forming in the substrate (10) spaced apart third and fourth regions (90, 92) of the second conductivity type, defining a second channel region therebetween, wherein the first logic gate (102) is disposed over the second channel region;
wherein the forming of the floating gate (110) includes depositing a first polysilicon layer (14) over and insulated from the substrate (10), and etching through the first polysilicon layer (14) leaving a block of the first polysilicon layer (14) that constitutes the floating gate (110);
wherein the forming of the control gate (112) includes depositing a second polysilicon layer (32) over and insulated from the first polysilicon layer (14), and etching through the second polysilicon layer (32) leaving a block of the second polysilicon layer (32) that constitutes the control gate (112);
wherein the forming of the erase gate (114) includes depositing a third polysilicon layer (54) over and insulated from the first region (50);
wherein the forming of the select gate (116) includes depositing a fourth polysilicon layer (74) over and insulated from the substrate (10), and etching through a first portion of the fourth polysilicon layer (74) leaving a first block of the fourth polysilicon layer (74) laterally adjacent to and insulated from the floating gate (110) and the control gate (112);
wherein the forming of the first logic gate (102) includes forming an oxide layer (76) over a second portion of the fourth polysilicon layer (74) such that the first portion of the fourth polysilicon layer (74) is left exposed,
**characterized in that**, the method further comprises
forming polysilicon (78) over the oxide layer (76) and thickening the first portion of the fourth polysilicon layer (74), removing the polysilicon (78) over the oxide layer (76) and reducing a height of the first portion of the fourth polysilicon layer (74), removing the oxide layer (76), and etching through the second portion of the fourth polysilicon layer (74) leaving a second block of the fourth polysilicon layer (74), wherein the first block of the fourth polysilicon layer (74) has a height greater than that of the second block of the fourth polysilicon layer (74).

2. The method of claim 1, wherein the forming of the floating gate includes:
forming a first insulation layer (12) on the substrate (10),
forming the first polysilicon layer (14) on the first insulation layer (12),
performing a first etch to form a first trench (42) through the first polysilicon layer (14), and
performing a second etch different than the first etch to form a second trench (100) through the first polysilicon layer (14),
wherein the floating gate (110) constitutes the first polysilicon layer (14) between the first and second trenches (42, 100),
wherein the first region (50) is disposed under the first trench (42),
wherein a sidewall of the first polysilicon layer (14) at the first trench (42) has a negative slope (14a), and wherein a sidewall of the first polysilicon layer (14) at the second trench (100) is vertical, such that a width of the floating gate (110) at a top surface of the floating gate (110) is larger than that at a bottom surface of the floating gate (110).

3. The method of claim 2,
wherein the first logic gate (102) is further formed by
removing and replacing the second block of the fourth polysilicon layer (74) with a first block of metal material that constitutes the first logic gate (102).

4. The method of claim 3, further comprising forming a second logic device on the substrate (10) by:
forming a second logic gate (102) over and insulated from the substrate (10);
forming in the substrate (10) spaced apart fifth and sixth regions (84, 86) of the second conductivity type, defining a third channel region therebetween;
wherein the second logic gate (102) is disposed over the third channel region and is formed by
etching through the fourth polysilicon layer (74) leaving a third block of the fourth polysilicon layer (74);
removing and replacing the third block of the fourth polysilicon layer (74) with a second block of metal material that constitutes the second logic gate (102).

5. The method of claim 4, wherein:
the first logic gate (102) is insulated from the substrate (10) by a second insulation layer (68);
the second logic gate (102) is insulated from the substrate (10) by a third insulation layer (72);
the second insulation layer (68) is thicker than the third insulation layer (72).

6. The method of claim 4, wherein the first and second logic gates (102) each have a height lower than the height of the first block of the fourth polysilicon layer (74).

7. The method of claim 1,
wherein the first logic gate (102) is further formed by:
removing and replacing the second block of the fourth polysilicon layer (74) with a first block of metal material that constitutes the first logic gate (102);
wherein the select gate (116) is further formed by:
removing and replacing the first block of the fourth polysilicon layer (74) with a second block of metal material which constitutes the select gate (116).

8. The method of claim 7, further comprising forming a second logic device on the substrate by:
forming a second logic gate (102) over and insulated from the substrate (10);
forming in the substrate spaced (10) apart fifth and sixth regions (84, 86) of the second conductivity type, defining a third channel region therebetween;
wherein the second logic gate (102) is disposed over the third channel region and is formed by:
etching through the fourth polysilicon layer (74) leaving a third block of the fourth polysilicon layer (74),
removing and replacing the third block of the fourth polysilicon layer (74) with a third block of metal material that constitutes the second logic gate (102).

9. The method of claim 8, wherein:
the first logic gate (102) is insulated from the substrate (10) by a second insulation layer (68);
the second logic gate (102) is insulated from the substrate (10) by a third insulation layer (72);
the second insulation layer (68) is thicker than the third insulation layer (72).

10. The method of claim 8, wherein the first and second logic gates (102) each have a height lower than the height of the first block of the fourth polysilicon layer (74).

## Patentansprüche

1. Verfahren zum Bilden einer Speichervorrichtung, umfassend:
Bilden, in einem Substrat (10) eines ersten Leitfähigkeitstyps, von voneinander beabstandeten ersten und zweiten Regionen (50, 82) eines zweiten Leitfähigkeitstyps, wodurch eine Kanalregion dazwischen definiert wird;
Bilden eines Floating-Gates (110), das über einem ersten Abschnitt der Kanalregion, die an die erste Region (50) angrenzt, angeordnet und von diesem isoliert ist;
Bilden eines Steuer-Gates (112), das über dem Floating-Gate (110) angeordnet und von diesem isoliert ist;
Bilden eines Lösch-Gates (114), das über der ersten Region (50) angeordnet und von dieser isoliert ist;
Bilden eines Auswahl-Gates (116) über einem zweiten Abschnitt der Kanalregion, die an die zweite Region (82) angrenzt, und von diesem isoliert;
Bilden eines ersten Logik-Gates (102) über dem Substrat (10) und von diesem isoliert;
Bilden, in dem Substrat (10), von voneinander beabstandeten dritten und vierten Regionen (90, 92) des zweiten Leitfähigkeitstyps, wodurch eine zweite Kanalregion dazwischen definiert wird, wobei das erste Logik-Gate (102) über der zweiten Kanalregion angeordnet ist;
wobei das Bilden des Floating-Gates (110) das Abscheiden einer ersten Polysiliziumschicht (14) über dem Substrat (10) und von diesem isoliert und das Ätzen durch die erste Polysiliziumschicht (14) einschließt, wodurch ein Block der ersten Polysiliziumschicht (14) zurückbleibt, der das Floating-Gate (110) bildet;
wobei das Bilden des Steuer-Gates (112) das Abscheiden einer zweiten Polysiliziumschicht (32) über der ersten Polysiliziumschicht (14) und von dieser isoliert und das Ätzen durch die zweite Polysiliziumschicht (32) einschließt, wodurch ein Block der zweiten Polysiliziumschicht (32) zurückbleibt, der das Steuer-Gate (112) bildet;
wobei das Bilden des Lösch-Gates (114) das Abscheiden einer dritten Polysiliziumschicht (54) über der ersten Region (50) und von dieser isoliert einschließt;
wobei das Bilden des Auswahl-Gates (116) das Abscheiden einer vierten Polysiliziumschicht (74) über dem Substrat (10) und von diesem isoliert und das Ätzen durch einen ersten Abschnitt der vierten Polysiliziumschicht (74) einschließt, wodurch ein erster Block der vierten Polysiliziumschicht (74) seitlich angrenzend an das Floating-Gate (110) und das Steuer-Gate (112) und von diesen isoliert zurückbleibt;
wobei das Bilden des ersten Logik-Gates (102) das Bilden einer Oxidschicht (76) über einem zweiten Abschnitt der vierten Polysiliziumschicht (74) einschließt, so dass der erste Abschnitt der vierten Polysiliziumschicht (74) freigelegt bleibt,
**dadurch gekennzeichnet, dass** das Verfahren ferner umfasst
Bilden von Polysilizium (78) über der Oxidschicht (76) und Verdicken des ersten Abschnitts der vierten Polysiliziumschicht (74), Entfernen des Polysiliziums (78) über der Oxidschicht (76) und Reduzieren einer Höhe des ersten Abschnitts der vierten Polysiliziumschicht (74), Entfernen der Oxidschicht (76) und Ätzen durch den zweiten Abschnitt der vierten Polysiliziumschicht (74), wodurch ein zweiter Block der vierten Polysiliziumschicht (74) zurückbleibt, wobei der erste Block der vierten Polysiliziumschicht (74) eine Höhe aufweist, die größer ist als die des zweiten Blocks der vierten Polysiliziumschicht (74).

2. Verfahren nach Anspruch 1, wobei das Bilden des Floating-Gates einschließt:
Bilden einer ersten Isolierschicht (12) auf dem Substrat (10),
Bilden der ersten Polysiliziumschicht (14) auf der ersten Isolierschicht (12),
Durchführen einer ersten Ätzung, um einen ersten Graben (42) durch die erste Polysiliziumschicht (14) zu bilden, und
Durchführen einer zweiten Ätzung, die sich von der ersten Ätzung unterscheidet, um einen zweiten Graben (100) durch die erste Polysiliziumschicht (14) zu bilden,
wobei das Floating-Gate (110) die erste Polysiliziumschicht (14) zwischen dem ersten und dem zweiten Graben (42, 100) bildet,
wobei die erste Region (50) unter dem ersten Graben (42) angeordnet ist,
wobei eine Seitenwand der ersten Polysiliziumschicht (14) an dem ersten Graben (42) eine negative Steigung (14a) aufweist und wobei eine Seitenwand der ersten Polysiliziumschicht (14) an dem zweiten Graben (100) vertikal ist, so dass eine Breite des Floating-Gates (110) an einer oberen Oberfläche des Floating-Gates (110) größer ist als die an einer unteren Oberfläche des Floating-Gates (110).

3. Verfahren nach Anspruch 2,
wobei das erste Logik-Gate (102) ferner gebildet wird durch
Entfernen und Ersetzen des zweiten Blocks der vierten Polysiliziumschicht (74) durch einen ersten Block aus Metallmaterial, der das erste Logik-Gate (102) bildet.

4. Verfahren nach Anspruch 3, ferner umfassend das Bilden einer zweiten Logikvorrichtung auf dem Substrat (10) durch:
Bilden eines zweiten Logik-Gates (102) über dem Substrat (10) und von diesem isoliert;
Bilden, in dem Substrat (10), von voneinander beabstandeten fünften und sechsten Regionen (84, 86) des zweiten Leitfähigkeitstyps, wodurch eine dritte Kanalregion dazwischen definiert wird;
wobei das zweite Logik-Gate (102) über der dritten Kanalregion angeordnet ist und gebildet wird durch
Ätzen durch die vierte Polysiliziumschicht (74), wodurch ein dritter Block der vierten Polysiliziumschicht (74) zurückbleibt;
Entfernen und Ersetzen des dritten Blocks der vierten Polysiliziumschicht (74) durch einen zweiten Block aus Metallmaterial, der das zweite Logik-Gate (102) bildet.

5. Verfahren nach Anspruch 4, wobei:
das erste Logik-Gate (102) durch eine zweite Isolierschicht (68) von dem Substrat (10) isoliert ist;
das zweite Logik-Gate (102) durch eine dritte Isolierschicht (72) von dem Substrat (10) isoliert ist;
die zweite Isolierschicht (68) dicker als die dritte Isolierschicht (72) ist.

6. Verfahren nach Anspruch 4, wobei das erste und das zweite Logik-Gate (102) jeweils eine Höhe aufweisen, die niedriger ist als die Höhe des ersten Blocks der vierten Polysiliziumschicht (74).

7. Verfahren nach Anspruch 1,
wobei das erste Logik-Gate (102) ferner gebildet wird durch:
Entfernen und Ersetzen des zweiten Blocks der vierten Polysiliziumschicht (74) durch einen ersten Block aus Metallmaterial, der das erste Logik-Gate (102) bildet;
wobei das Auswahl-Gate (116) ferner gebildet wird durch:
Entfernen und Ersetzen des ersten Blocks der vierten Polysiliziumschicht (74) durch einen zweiten Block aus Metallmaterial, der das Auswahl-Gate (116) bildet.

8. Verfahren nach Anspruch 7, ferner umfassend das Bilden einer zweiten Logikvorrichtung auf dem Substrat durch:
Bilden eines zweiten Logik-Gates (102) über dem Substrat (10) und von diesem isoliert;
Bilden, in dem Substrat (10), von voneinander beabstandeten fünften und sechsten Regionen (84, 86) des zweiten Leitfähigkeitstyps, wodurch eine dritte Kanalregion dazwischen definiert wird;
wobei das zweite Logik-Gate (102) über der dritten Kanalregion angeordnet ist und gebildet wird durch:
Ätzen durch die vierte Polysiliziumschicht (74), wodurch ein dritter Block der vierten Polysiliziumschicht (74) zurückbleibt,
Entfernen und Ersetzen des dritten Blocks der vierten Polysiliziumschicht (74) durch einen dritten Block aus Metallmaterial, der das zweite Logik-Gate (102) bildet.

9. Verfahren nach Anspruch 8, wobei:
das erste Logik-Gate (102) durch eine zweite Isolierschicht (68) von dem Substrat (10) isoliert ist;
das zweite Logik-Gate (102) durch eine dritte Isolierschicht (72) von dem Substrat (10) isoliert ist;
die zweite Isolierschicht (68) dicker als die dritte Isolierschicht (72) ist.

10. Verfahren nach Anspruch 8, wobei das erste und das zweite Logik-Gate (102) jeweils eine Höhe aufweisen, die niedriger ist als die Höhe des ersten Blocks der vierten Polysiliziumschicht (74).

## Revendications

1. Procédé de formation d'un dispositif de mémoire, comprenant :
la formation, dans un substrat (10) d'un premier type de conductivité, de première et deuxième régions espacées (50, 82) d'un deuxième type de conductivité, définissant une région de canal entre elles ;
la formation d'une grille flottante (110) disposée par-dessus et isolée d'une première partie de la région de canal qui est adjacente à la première région (50) ;
la formation d'une grille de commande (112) disposée par-dessus et isolée de la grille flottante (110) ;
la formation d'une grille d'effacement (114) disposée par-dessus et isolée de la première région (50) ;
la formation d'une grille de sélection (116) par-dessus et isolée d'une deuxième partie de la région de canal qui est adjacente à la deuxième région (82) ;
la formation d'une première grille logique (102) par-dessus et isolée du substrat (10) ;
la formation dans le substrat (10) de troisième et quatrième régions espacées (90, 92) du deuxième type de conductivité, définissant une deuxième région de canal entre elles, dans lequel la première grille logique (102) est disposée par-dessus la deuxième région de canal ;
dans lequel la formation de la grille flottante (110) inclut le dépôt d'une première couche de silicium polycristallin (14) par-dessus et isolée du substrat (10), et la gravure à travers la première couche de silicium polycristallin (14) en laissant un bloc de la première couche de silicium polycristallin (14) qui constitue la grille flottante (110) ;
dans lequel la formation de la grille de commande (112) inclut le dépôt d'une deuxième couche de silicium polycristallin (32) par-dessus et isolée de la première couche de silicium polycristallin (14), et la gravure à travers la deuxième couche de silicium polycristallin (32) en laissant un bloc de la deuxième couche de silicium polycristallin (32) qui constitue la grille de commande (112) ;
dans lequel la formation de la grille d'effacement (114) inclut le dépôt d'une troisième couche de silicium polycristallin (54) par-dessus et isolée de la première région (50) ;
dans lequel la formation de la grille de sélection (116) inclut le dépôt d'une quatrième couche de silicium polycristallin (74) par-dessus et isolée du substrat (10), et la gravure à travers une première partie de la quatrième couche de silicium polycristallin (74) en laissant un premier bloc de la quatrième couche de silicium polycristallin (74) latéralement adjacent à et isolé de la grille flottante (110) et de la grille de commande (112) ;
dans lequel la formation de la première grille logique (102) inclut la formation d'une couche d'oxyde (76) par-dessus une deuxième partie de la quatrième couche de silicium polycristallin (74) de sorte que la première partie de la quatrième couche de silicium polycristallin (74) reste exposée,
**caractérisé en ce que,** le procédé comprend en outre
la formation de silicium polycristallin (78) par-dessus la couche d'oxyde (76) et l'épaississement de la première partie de la quatrième couche de silicium polycristallin (74), l'élimination du silicium polycristallin (78) par-dessus la couche d'oxyde (76) et la réduction d'une hauteur de la première partie de la quatrième couche de silicium polycristallin (74), l'élimination de la couche d'oxyde (76), et la gravure à travers la deuxième partie de la quatrième couche de silicium polycristallin (74) en laissant un deuxième bloc de la quatrième couche de silicium polycristallin (74), dans lequel le premier bloc de la quatrième couche de silicium polycristallin (74) a une hauteur supérieure à celle du deuxième bloc de la quatrième couche de silicium polycristallin (74).

2. Procédé selon la revendication 1, dans lequel la formation de la grille flottante inclut :
la formation d'une première couche d'isolation (12) sur le substrat (10),
la formation de la première couche de silicium polycristallin (14) sur la première couche d'isolation (12),
la mise en oeuvre d'une première gravure pour former une première tranchée (42) à travers la première couche de silicium polycristallin (14), et
la mise en œuvre d'une deuxième gravure différente de la première gravure pour former une deuxième tranchée (100) à travers la première couche de silicium polycristallin (14),
dans lequel la grille flottante (110) constitue la première couche de silicium polycristallin (14) entre les première et deuxième tranchées (42, 100),
dans lequel la première région (50) est disposée sous la première tranchée (42),
dans lequel une paroi latérale de la première couche de silicium polycristallin (14) au niveau de la première tranchée (42) a une pente négative (14a), et dans lequel une paroi latérale de la première couche de silicium polycristallin (14) au niveau de la deuxième tranchée (100) est verticale, de sorte qu'une largeur de la grille flottante (110) au niveau d'une surface supérieure de la grille flottante (110) est plus grande que celle au niveau d'une surface inférieure de la grille flottante (110).

3. Procédé selon la revendication 2,
dans lequel la première grille logique (102) est en outre formée par
l'élimination et le remplacement du deuxième bloc de la quatrième couche de silicium polycristallin (74) par un premier bloc de matériau métallique qui constitue la première grille logique (102).

4. Procédé selon la revendication 3, comprenant en outre la formation d'un deuxième dispositif logique sur le substrat (10) par :
la formation d'une deuxième grille logique (102) par-dessus et isolée du substrat (10) ;
la formation dans le substrat (10) de cinquième et sixième régions espacées (84, 86) du deuxième type de conductivité, définissant une troisième région de canal entre elles ;
dans lequel la deuxième grille logique (102) est disposée par-dessus la troisième région de canal et est formée par
la gravure à travers la quatrième couche de silicium polycristallin (74) en laissant un troisième bloc de la quatrième couche de silicium polycristallin (74) ;
l'élimination et le remplacement du troisième bloc de la quatrième couche de silicium polycristallin (74) par un deuxième bloc de matériau métallique qui constitue la deuxième grille logique (102).

5. Procédé selon la revendication 4, dans lequel :
la première grille logique (102) est isolée du substrat (10) par une deuxième couche d'isolation (68) ;
la deuxième grille logique (102) est isolée du substrat (10) par une troisième couche d'isolation (72) ;
la deuxième couche d'isolation (68) est plus épaisse que la troisième couche d'isolation (72).

6. Procédé selon la revendication 4, dans lequel les première et deuxième grilles logiques (102) ont chacune une hauteur inférieure à la hauteur du premier bloc de la quatrième couche de silicium polycristallin (74).

7. Procédé selon la revendication 1,
dans lequel la première grille logique (102) est en outre formée par :
l'élimination et le remplacement du deuxième bloc de la quatrième couche de silicium polycristallin (74) par un premier bloc de matériau métallique qui constitue la première grille logique (102) ;
dans lequel la grille de sélection (116) est en outre formée par :
l'élimination et le remplacement du premier bloc de la quatrième couche de silicium polycristallin (74) par un deuxième bloc de matériau métallique qui constitue la grille de sélection (116).

8. Procédé selon la revendication 7, comprenant en outre la formation d'un deuxième dispositif logique sur le substrat par :
la formation d'une deuxième grille logique (102) par-dessus et isolée du substrat (10) ;
la formation dans le substrat (10) de cinquième et sixième régions espacées (84, 86) du deuxième type de conductivité, définissant une troisième région de canal entre elles ;
dans lequel la deuxième grille logique (102) est disposée par-dessus la troisième région de canal et est formée par :
la gravure à travers la quatrième couche de silicium polycristallin (74) en laissant un troisième bloc de la quatrième couche de silicium polycristallin (74),
l'élimination et le remplacement du troisième bloc de la quatrième couche de silicium polycristallin (74) par un troisième bloc de matériau métallique qui constitue la deuxième grille logique (102).

9. Procédé selon la revendication 8, dans lequel :
la première grille logique (102) est isolée du substrat (10) par une deuxième couche d'isolation (68) ;
la deuxième grille logique (102) est isolée du substrat (10) par une troisième couche d'isolation (72) ;
la deuxième couche d'isolation (68) est plus épaisse que la troisième couche d'isolation (72).

10. Procédé selon la revendication 8, dans lequel les première et deuxième grilles logiques (102) ont chacune une hauteur inférieure à la hauteur du premier bloc de la quatrième couche de silicium polycristallin (74).
